# EUROPEAN PATENT APPLICATION

(11) **EP 2 006 756 A1**
(43) Date of publication of application: **24.12.2008**
(21) Application number: 07110797.3
(22) Date of filing: 21.06.2007
(51) Int. Cl.: G05D 23/20, H03B 5/04, H03L 1/04

(54) **Integrated circuit adapted for heating a chamber under constant temperature condition, and heating control circuit and electronic device having the same**

(71) Applicant: Taitien Electronics Co., Ltd., Taipei (TW)
(72) Inventor: Lee, Tung-Teh, Taipei (TW)
(74) Representative: Sherrard-Smith, Hugh

(57) **Abstract**

An integrated circuit (10) is adapted for heating a chamber (20), and includes a control module (12) operable so as to generate a control signal (Vₒ) according to a desired temperature, and a heater (13) connected electrically to the control module (22) for heating the chamber (20) in accordance with the control signal (Vₒ) from the control module (12) so as to maintain the temperature in the chamber (20) at the desired temperature. A heating control circuit (1) and an electronic device (100) including the heating control circuit (10) are also disclosed.

## Description

The invention relates to a heating circuit, more particularly to an integrated circuit, a heating control circuit and an electronic device for heating a chamber under a constant temperature condition.

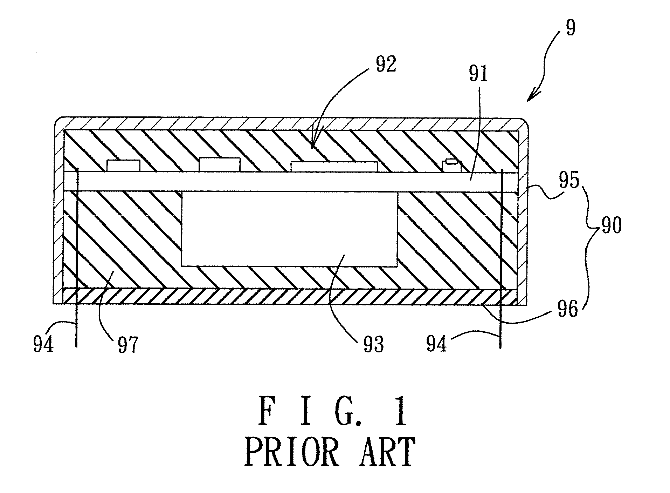

Figure 1 illustrates a conventional crystal oscillator device 9 that can generate a predetermined oscillator frequency under a constant temperature condition. The conventional crystal oscillator device 9 includes a package housing 95, a circuit board 91, a heating circuit 92 and a crystal oscillator 93. The package housing 90 has a base plate 96, such as a printed circuit board, and a metal cover 95 for covering sealingly the base plate 96. The base plate 96 cooperates with the cover 95 to define a chamber therebetween. The circuit board 91 is disposed fixedly in the chamber. The crystal oscillator 93 is mounted on a bottom surface of the circuit board 91. The heating circuit 92 is mounted on a top surface of the circuit board 91 for heating the chamber in accordance with variation of the temperature in the chamber so as to maintain the temperature in the chamber at a predetermined temperature, thereby ensuring that the crystal oscillator 93 can generate a predetermined oscillator frequency. The circuit board 91 has a plurality of connecting pins 94 extending outwardly of the package housing 90 through the base plate 96. A foam material 97 is filled within the chamber.

Since the heating circuit 92 includes a plurality of separate electronic components, the package housing 90 has a relatively large size. Therefore, to maintain the chamber in a constant temperature condition, power consumption of the conventional crystal oscillator device 9 is increased.

Therefore, the object of the present invention is to provide an integrated circuit, a heating control circuit and an electronic device that can heat a chamber under a constant temperature condition with relatively low power consumption.

According to one aspect of the present invention, there is provided an integrated circuit adapted for heating a chamber. The integrated circuit comprises:
a control module operable so as to generate a control signal according to a desired temperature; and
a heater connected electrically to the control module for heating the chamber in accordance with the control signal from the control module so as to maintain the temperature in the chamber at the desired temperature.

According to another aspect of the present invention, there is provided a heating control circuit adapted for heating a chamber. The heating control circuit comprises:
an operating unit operable so as to generate an adjusting output corresponding to a desired temperature;
a control module connected electrically to the operating unit for generating a control signal in accordance with the adjusting output from the operating unit; and
a heater connected electrically to the control module and adapted for heating the chamber in accordance with the control signal from the control module so as to maintain the temperature in the chamber at the desired temperature.

According to a further aspect of the present invention, an electronic device comprises:
a package housing configured with a chamber and having a plurality of conductive contacts that are exposed outwardly of the package housing;
a circuit board disposed in the chamber and connected electrically to the conductive contacts of the package housing;
a heating control circuit mounted on the circuit board for heating the chamber so as to maintain the temperature in the chamber at a predetermined temperature; and
an electronic component mounted on the circuit board and operable so as to generate a predetermined output corresponding to the predetermined temperature.

The heating control circuit includes
an operating unit operable so as to generate an adjusting output corresponding to the predetermined temperature,
a control module connected electrically to the operating unit for generating a control signal in accordance with the adjusting output from the operating unit, and
a heater connected electrically to the control module for heating the chamber in accordance with the control signal from the control module so as to maintain the temperature in the chamber at the predetermined temperature.

Other features and advantages of the present invention will become apparent in the following detailed description of the preferred embodiments with reference to the accompanying drawings, of which:
Figure 1 is a schematic partly sectional view of a conventional crystal oscillator device;
Figure 2 is a schematic partly sectional view showing the preferred embodiment of an electronic device according to the present invention;
Figure 3 is a schematic circuit block diagram showing a heating control circuit of the preferred embodiment;
Figure 4 is a schematic electrical circuit diagram showing the heating control circuit of the preferred embodiment; and
Figure 5 is a schematic electrical circuit diagram showing another embodiment of the heating control circuit according to the present invention.

Before the present invention is described in greater detail, it should be noted that like elements are denoted by the same reference numerals throughout the disclosure.

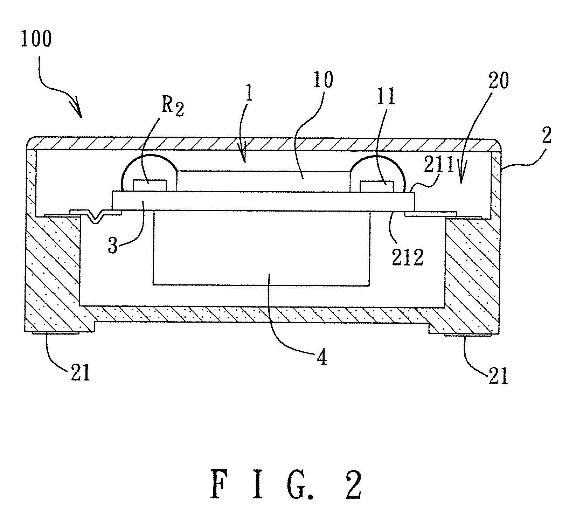

Referring to Figure 2, the preferred embodiment of an electronic device 100 according to the present invention is shown to include a package housing 2, a circuit board 3, a heating control circuit 1, and an electronic component.

The package housing 2 is configured with a vacuum chamber 20, and has a plurality of conductive contacts 21 that are exposed outwardly of the package housing 2.

The circuit board 3 is disposed in the chamber 20, and is connected electrically to the conductive contacts of the package housing 2. The circuit board 3 has opposite first and second surfaces 211, 212.

The heating control circuit 1 is mounted on the first surface 211 of the circuit board 3 for heating the chamber 20 so as to maintain the temperature in the chamber 20 at a desired temperature.

The electronic component 4 is mounted on the second surface 212 of the circuit board 3, and is operable so as to generate a predetermined output corresponding to the desired temperature. In this embodiment, the electronic component 4 is an active component, such as a crystal oscillator, for generating an oscillator frequency corresponding to the temperature in the chamber 20. In other embodiments, the electronic component 4 can be a passive component, such as a resistor, a capacitor or an inductor, for generating an electrical signal corresponding to the temperature in the chamber 20.

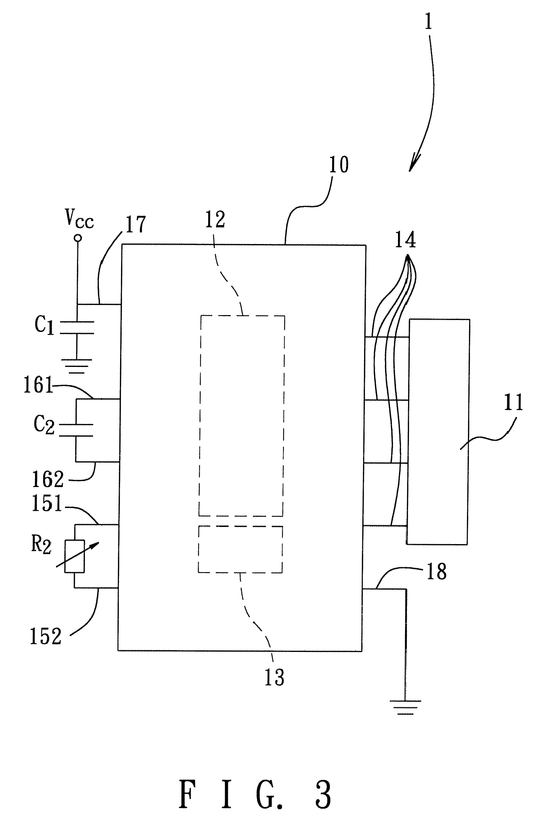

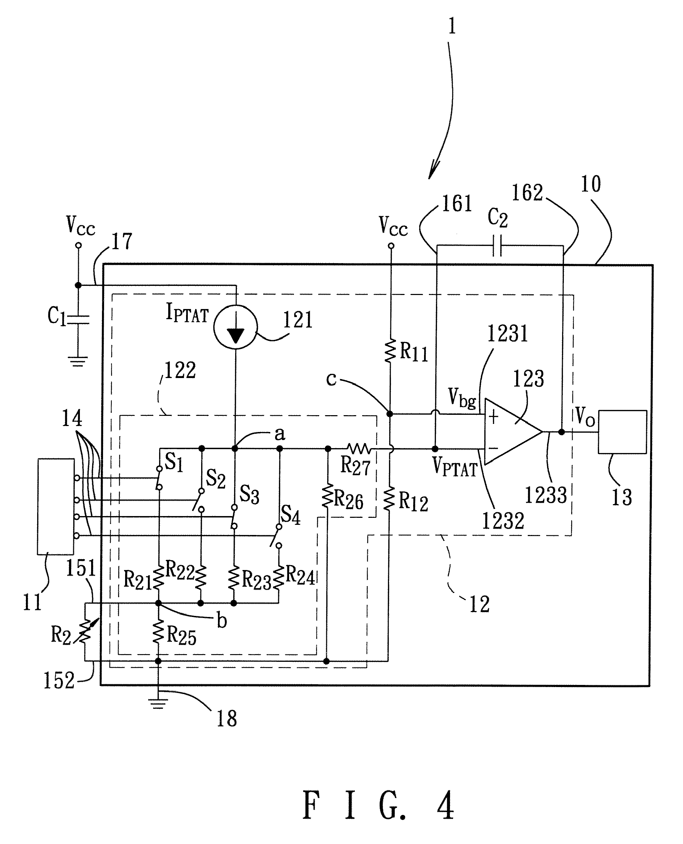

Referring further to Figures 3 and 4, the heating control circuit 1 includes an operating unit 11, an integrated circuit 10, a variable resistor (R2), and capacitors (C1, C2).

The operating unit 11 is operable so as to generate an adjusting output corresponding to the desired temperature. The adjusting output from the operating unit 11 has a number (N) of adjusting signals, wherein N=4 in this embodiment such that the operating unit 11 is capable of generating 2⁴ different outputs as the adjusting output.

The integrated circuit 10 includes a control module 12 operable so as to generate a control signal (Vₒ), which is a voltage signal, and a heater 13 connected electrically to the control module 12 for heating the chamber 20 in accordance with the control signal (Vₒ) from the control module 12 so as to maintain the temperature in the chamber 20 at the desired temperature.

The integrated circuit 10 has four first connecting pins 14 connected electrically to the operating unit 11 for receiving respectively the adjusting signals of the adjusting output therefrom, two second connecting pins 151, 152 connected electrically and respectively to opposite ends of the variable resistor (R2), two third connecting pins 161, 162 connected electrically and respectively to opposite terminals of the capacitor (C2), a fourth connecting pin 17 connected electrically to the capacitor (C1) and adapted to be connected electrically to a power source, and a grounded fifth connecting pin 18.

The control module 12 includes a current source 121, a variable resistor unit 122, and a control unit 123. The current source 121 is connected electrically to the fourth connecting pin 17, and generates a current output (I_{PTAT}) proportional to the temperature of the chamber 20 in the package housing 2.

The variable resistor unit 122 is connected electrically to the current source 121 and the first connecting pins 14 for receiving respectively the current output (I_{PTAT}) and the adjusting signals therefrom. The variable resistor unit 122 is controlled by the adjusting signals of the adjusting output from the operating unit 11 to have a selected resistance so as to generate an adjusting voltage output (V_{PTAT}). In this embodiment, the variable resistor unit 122 includes a first node (a) connected electrically to the current source 121, a second node (b) connected electrically to the second connecting pin 151, four series-connected units, each of which has a switch (S₁, S₂, S₃, S₄) and a first resistor (R₂₁, R₂₂, R₂₃, R₂₄), connected in parallel between the first and second nodes (a, b), a second resistor (R₂₅) connected between the second node (b) and the fifth connecting pin 18, a third resistor (R₂₆) connected between the first node (a) and the fifth connecting pin 18, and a fourth resistor (R₂₇) having one end connected to the first node (a). The switch (S₁, S₂, S₃, S₄) of each of the series-connected units has a first end connected electrically to the first node (a), and a second end connected electrically to the first resistor (R₂₁, R₂₂, R₂₃, R₂₄) thereof, and a control end connected electrically to a corresponding one of the first connecting pins 14 for receiving a corresponding one of the adjusting signals of the adjusting output from the operating unit 11 so as to control connection between the first and second ends in accordance with the corresponding one of the adjusting signals received thereby such that the variable resistor unit 122 has the selected resistance.

In this embodiment, the control unit 123 is a comparator, and has a first input end 1231 connected electrically to a node (c) between two resistors (R₁₁, R₁₂) for receiving a reference voltage (V_{bg}) that is a voltage across the resistor (R₁₁) independent of the temperature in the chamber 20, and a second input end 1232 connected electrically to the variable resistor unit 122 for receiving the adjusting voltage output (V_{PTAT}) therefrom, and an output end 1233 for outputting the control signal (Vₒ). The control unit 123 compares the adjusting voltage output (V_{PTAT}) 122 with the reference voltage (V_{bg}), and generates the control signal (Vₒ) based on the comparison result. When the adjusting voltage output (V_{PTAT}) is less than the reference voltage (V_{bg}), the heater 13 is activated in response to the control signal (Vₒ) from the control unit 123, whereas when the adjusting voltage output (V_{PTAT}) is greater than the reference voltage (V_{bg}), the heater 13 is deactivated in response to the control signal (Vₒ) from the control unit 123. Furthermore, the second input end 1232 and the output end 1233 of the control unit 123 are connected electrically and respectively to the third connecting pins 161, 162. It is noted that, due to the presence of the capacitor (C₂), oscillation of the control signal (Vₒ) can be avoided during deactivation of the heater 13.

In such a configuration, since 2⁴ the different outputs can be generated by the operating unit 11 as the adjusting output, the variable resistor unit 122 is capable of having 2⁴ different resistances associated respectively with different temperatures within a temperature range from a determined highest temperature (T2) to a determined lowest temperature (T1). Moreover, the variable resistor (R₂) is adjustable so that the desired temperature is tunable within a predetermined temperature variation equal to (T2-T1)/(2⁴-1). For example, the adjusting output is a 4-bit output represented as "b0b1b2b3", wherein each bit of the adjusting output serves as a corresponding one of the adjusting signals and can be one of "0" meaning that the switch (S₁, S₂, S₃, S₄) of a corresponding one of the series-connected units of the variable resistor unit 122 is controlled to be in an OFF-state, and "1" meaning that the switch (S₁, S₂, S₃, S₄) of a corresponding one of the series-connected units of the variable resistor unit 122 is controlled to be in an ON-state. As such, the 2⁴ different outputs generated by the operating unit 11 are shown in Table 1. At the same time, assume that the highest temperature (T2) is 90°C, and the lowest temperature (T1) is 60°C. As a result, the 2⁴ different temperatures corresponding respectively to the 2⁴ different outputs from the operating unit 11 are shown in Table 1. On the other hand, by adjusting the variable resistor (R₂), the desired temperature is tunable within 2°C (=(90-60)/(2⁴-1)).

**Table 1**

| b0 | b1 | b2 | b3 | Desired Temperature |
|---|---|---|---|---|
| 0 | 0 | 0 | 0 | 90°C |
| 0 | 0 | 0 | 1 | 88°C |
| 0 | 0 | 1 | 0 | 86°C |
| ... | ... | ... | ... | ... |
| 1 | 1 | 1 | 1 | 60°C |

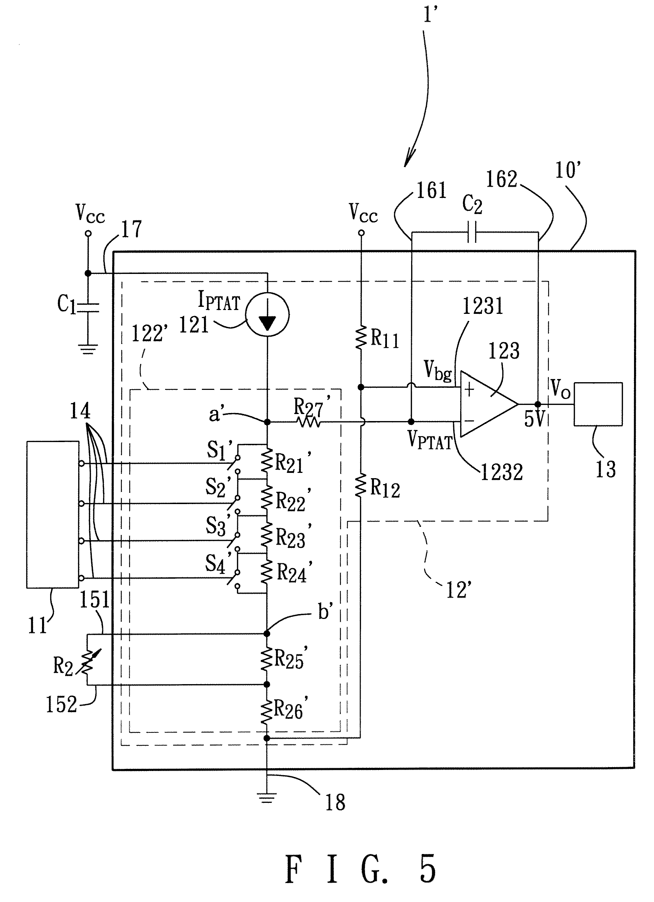

Figure 5 illustrates the heating control circuit 1' of another embodiment according to this invention, which is a modification of the first preferred embodiment. In this embodiment, the variable resistor unit 122' of the control module 12' of the integrated circuit 10' of the heating control circuit 1' includes a first node (a') connected electrically to the current source 121, a second node (b') connected electrically to the second connecting pin 151, a series connection of the number (N) of parallel-connected units, whereinN=4, connected electrically between the first and second nodes (a', b'), a second resistor (R_{25'}) and a third resistor (R_{26'}) connected in series between the second node (b') and ground, wherein a node between the second and third resistors (R_{25'}, R_{26'}) is connected electrically to the second connecting pin 152, and a fourth resistor (R_{27'}) connected electrically between the first node (a') and the second input end 1232 of the control unit 123.

Each of the parallel-connected units has a switch (S_{1'}, S_{2'}, S_{3'}, S_{4'}) and a first resistor (R_{21'}, R_{22'}, R_{23'}, R_{24'}). The switch (S_{1'}, S_{2'}, S_{3'}, S_{4'}) of each parallel-connected unit of the variable resistor unit 122' has first and second ends connected electrically and respectively to opposite ends of the first resistor (R_{21'}, R_{22'}, R_{23'}, R_{24'}) thereof, and a control end connected electrically to a corresponding one of the first connecting pins 14 for receiving a corresponding one of the adjusting signals of the adjusting output from the operating unit 11 so as to control connection between the first and second ends in accordance with the corresponding one of the adjusting signals received thereby such that the variable resistor unit 122' has the selected resistance.

In sum, due to the presence of the integrated circuit 10, 10', the heating control circuit 1, 1' has a smaller size as compared to that in the prior art, such that the package housing 2 has a relatively small size. Hence, the heating control circuit 1, 1' can maintain effectively the temperature in the chamber 20 at the desired temperature with decreased power consumption. Furthermore, the operating unit 11 and the variable resistor unit 122, 122' are designed to be operable to set the temperature in the chamber 20 as required. Therefore, the electronic device 100 of this invention can stably maintain a desired temperature condition with decreased power consumption.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment (s). The invention extends to any novel one, or any novel combination, of the features disclosed in this specification (including any accompanying claims, abstract and drawings), or to any novel one, or any novel combination, of the steps of any method or process so disclosed.

## Claims

1. An integrated circuit (10, 10') adapted for heating a chamber (20), **characterized by**:
a control module (12, 12') operable so as to generate a control signal (Vₒ) according to a desired temperature; and
a heater (13) connected electrically to said control module (12, 12') for heating the chamber (20) in accordance with the control signal (Vₒ) fromsaid control module (12, 12') so as to maintain the temperature in the chamber (20) at the desired temperature.

2. The integrated circuit (10, 10') as claimed in Claim 1, **characterized in that** the control signal (Vₒ) is a voltage signal.

3. The integrated circuit (10, 10') as claimed in Claim 2, further **characterized in that** said control module (12, 12') includes:
a current source (121) for genera ting a current output (I_{PTAT}) proportional to the temperature of the chamber (20);
a variable resistor unit (122, 122') operable so as to have a selected resistance that is associated with the desired temperature, and connected electrically to said current source (121) for receiving the current output (I_{PTAT}) therefrom so as to generate an adjusting voltage output (V_{PTAT}); and
a control unit (123) connected electrically to said variable resistor unit (122, 122' and said heater (13), comparing the adjusting voltage output (V_{PTAT}) from said variable resistor unit (122, 122') with a reference voltage (V_{bg}), and generating the control signal) based on the comparison result;
wherein, when the adjusting voltage output (V_{PTAT}) is less than the reference voltage (V_{bg}), said heater is activated in response to the control signal (Vₒ) from said control unit (123); and
wherein, when the adjusting voltage output (V_{PTAT}) is greater than the reference voltage (V_{bg}), said heater (13) is deactivated in response to the control signal (Vₒ) from said control unit (123).

4. The integrated circuit (10, 10') as claimed in Claim 3, further **characterized in that** said control unit (123) has first and second input ends (2231, 1232) receiving respectively the reference voltage (V_{bg}) and the adjusting voltage output (V_{PTAT}), and an output end (1233) for outputting the control signal (Vₒ), said integrated circuit (10, 10') further comprising two connecting pins (161, 162) connected electrically and respectively to said second input end (1232) and said output end (1233) of said control unit (123) and adapted for connecting to a capacitor (C₂) therebetween.

5. The integrated circuit (10) as claimed in Claim 3, further **characterized in that** said variable resistor unit (122) includes a first node (a) connected electrically to said current source (121), a second node (b), a number (N) of series-connected units, each of which has a switch (S₁, S₂, S₃, S₄) and a first resistor (R₂₁, R₂₂, R₂₃, R₂₄), connected in parallel between said first and second nodes, and a second resistor (R₂₅) connected between said second node (b) and ground.

6. The integrated circuit (10) as claimed in Claim 5, further **characterized in that** said switch (S₁, S₂, S₃, S₄) of each of said series-connected units has a first end connected electrically to said first node (a), a second end connected electrically to said first resistor (R₂₁, R₂₂, R₂₃, R₂₄) thereof, and a control end;
said integrated circuit (10) further comprising the number (N) of connecting pins (14) connected electrically and respectively to said control ends of said switches (S₁, S₂, S₃, S₄) of said series-connected units of said variable resistor unit (122), and adapted for receiving respectively the number (N) of adjusting signals from an operating unit (11) so as to control operation of said switch (S₁, S₂, S₃, S₄) of each of said series-connected units of said variable resistor unit (122) in accordance with a corresponding one of the adjusting signals received thereby such that said variable resistor unit (122) has the selected resistance; and
wherein the operating unit (11) is operable so that said variable resistor unit (122) is capable of having a number (2^{N}) of different resistances associated respectively with different temperatures within a temperature range from a determined highest temperature (T2) to a determined lowest temperature (T1).

7. The integrated circuit (10) as claimed in Claim 6, further **characterized by** two connecting pins (151, 152) connected electrically and respectively to opposite ends of said second resistor (R₂₅) of said variable resistor unit (122) and adapted for connecting to a variable resistor (R₂) therebetween.

8. The integrated circuit (10') as claimed in Claim 3, further **characterized in that** said variable resistor unit (122') includes a series connection of a number (N) of parallel-connected units, each of which has a swi tch and a first resistor (R_{21'}, R_{22'}, R_{23'}, R_{24'}), said series connection being connected electrically between said current source (121) and ground.

9. The integrated circuit (10') as claimed in Claim 8, further **characterized in that** said switch (S₁, S₂, S₃, S₄) of each of said parallel-connected units of said variable resistor unit (122') has first and second ends connected electrically and respectively to opposite ends of said first resistor (R_{21'}, R_{22'}, R_{23'}, R_{24'}) thereof, and a control end;
said integrated circuit (10') further comprising the number (N) of connecting pins (14) connected electrically and respectively to said control ends of said switches (S₁, S₂, S₃, S₄) of said parallel-connected units of said variable resistor unit (122'), and adapted for receiving respectively the number (N) of adjusting signals from an operating unit (11) so as to control operation of said switch (S₁, S₂, S₃, S₄) of each of said parallel-connected units of said variable resistor unit (122') in accordance with a corresponding one of the adjusting signals received thereby such that said variable resistor unit (122') has the selected resistance; and
wherein the operating unit (11) is operable so that said variable resistor unit (122') is capable of having a number (2^{N}) of different resistances associated respectively with different temperatures within a temperature range from a determined highest temperature (T2) to a determined lowest temperature (T1).

10. The integrated circuit (10') as claimed in Claim 9, further **characterized in that** said variable resistor unit (122') further includes a second resistor (R_{25'}) and a third resistor (R_{26'}) connected in series and connecting said series connection and the ground, said integrated circuit (10') further comprising two connecting pins (151, 152) connected electrically and respectively to opposite ends of said second resistor (R_{25'}) of said variable resistor unit (122') and adapted for connecting to a variable resistor (R₂) therebetween.

11. A heating control circuit (1, 1') adapted for heating a chamber (20), **characterized by**:
an operating unit (11) operable so as to generate an adjusting output corresponding to a desired temperature;
a control module (12, 12') connected electrically to said operating unit (11) for generating a control signal (Vₒ) in accordance with the adjusting output from said operating unit (11); and
a heater (13) connected electrically to said control module (12, 12') and adapted for heating the chamber (20) in accordance with the control signal (Vₒ) from said control module (12, 12') so as to maintain the temperature in the chamber (20) at the desired temperature.

12. The heating control circuit (1, 1') as claimed in Claim 11, **characterized in that**:
the control signal (Vₒ) is a voltage signal;
said control module (12, 12') includes
a current source (121) for generating a current output (I_{PTAT}) proportional to the temperature of the chamber (20),
a variable resistor unit (122, 122') connected electrically to said current source (121) and said operating unit (11) for receiving respectively the current output (I_{PTAT}) and the adjusting output therefrom, said variable resistor unit (122,122') being controlled by the adjusting output from said operating unit (11) to have a selected resistance so as to generate an adjusting voltage output (V_{PTAT}), and
a control unit (123) connected electrically to said variable resistor unit (122, 122') and said heater (13), comparing the adjusting voltage output (V_{PTAT}) from said variable resistor unit (122, 122') with a reference voltage (V_{bg}), and generating the control signal (Vₒ) based on the comparison result;
when the adjusting voltage output (V_{PTAT}) is less than the reference voltage (V_{bg}), said heater (13) is activated in response to the control signal (Vₒ) from said control unit (123); and
when the adjusting voltage output (V_{PTAT}) is greater than the reference voltage (V_{bg}), said heater (13) is deactivated in response to the control signal (Vₒ) from said control unit (123).

13. The heating control circuit (1, 1') as claimed in Claim 12, further **characterized in that** said control unit (123) has first and second input ends (1231, 1232) receiving respectively the reference Voltage (V_{bg}) and the adjusting voltage output (V_{PTAT}), and an output end (1233) for outputting the control signal (Vₒ), said heating control circuit (1, 1') further **characterized by** a capacitor (C₂) connected electrically between said second input end (1232) and said output end (1233) of said control unit (123).

14. The heating control circuit (1) as claimed in Claim 12, further **characterized in that** said variable resistor unit (122) includes a first node (a) connected electrically to said current source (121), a second node (b), a number (N) of series-connected units, each of which has a switch (S₁, S₂, S₃, S₄) and a first resistor (R₂₁, R₂₂, R₂₃, R₂₄), connected in parallel between said first and second nodes (a, b), and a second resistor (R₂₅) connected between said second node (b) and ground.

15. The heating control circuit (1) as claimed in Claim 14, further **characterized in that**:
the adjusting output from said operating unit (11) includes the number (N) of adjusting signals;
said switch (S₁, S₂, S₃, S₄) of each of said series-connected units has a first end connected electrically to said first node (a), a second end connected electrically to said first resistor thereof, and a control end for receiving a corresponding one of the adjusting signals of the adjusting output from said operating unit (11) so as to control connection between said first and second ends in accordance with the corresponding one of the adjusting signals received thereby such that said variable resistor unit (122) has the selected resistance; and
said operating unit (11) is operable so that said variable resistor unit (122) is capable of having a number (2^{N}) of different resistances associated respectively with different temperatures within a temperature range from a determined highest temperature (T2) to a determined lowest temperature (T1).

16. The heating control circuit (1) as claimed in Claim 15, further **characterized by** a variable resistor (R₂) connected in parallel to said second resistor (R₂₅) of said variable resistor unit (122);
wherein said variable resistor (R₂) is adjustable so that the desired temperature is tunable within a predetermined temperature variation equal to (T2-T1)/(2^{N}-1).

17. The heating control circuit (1') as claimed in Claim 12, **characterized in that** said variable resistor unit (122') includes a series connection of a number (N) of parallel-connected units, each of which has a switch (S_{1'}, S_{2'}, S_{3'}, S_{4'}) and a first resistor (R_{21'}, R_{22'}, R_{23'}, R_{24'}), said series connection being connected electrically between said current source (121) and ground.

18. The heating control circuit (1') as claimed in Claim 17, further **characterized in that**:
the adjusting output from said operating unit (11) includes the number (N) of adjusting signals;
said switch (S_{1'}, S_{2'}, S_{3'}, S_{4'}) of each of said parallel-connected units of said variable resistor unit (122') has first and second ends connected electrically and respectively to opposite ends of said first resistor (R_{21'}, R_{22'}, R_{23'}, R_{24'}) thereof, and a control end for receiving a corresponding one of the adjusting signals of the adjusting output from said operating unit (11) so as to control connection between said first and second ends in accordance with the corresponding one of the adjusting signals received thereby such that said variable resistor unit (122') has the selected resistance; and
said operating unit (11) is operable so that said variable resistor unit (122') is capable of having a number (2^{N}) of different resistances associated respectively with different temperatures within a temperature range from a determined highest temperature (T2) to a determined lowest temperature (T1).

19. The heating control circuit (1') as claimed in Claim 18, further **characterized in that** said variable resistor unit (122') further includes a second resistor (R₂₅,) and a third resistor (R_{26'}) connected in series and connecting said series connection and the ground, said heating control circuit (1') further **characterized by** a variable resistor (R₂) connected in parallel to said second resistor (R_{25'}) of said variable resistor unit (122');
wherein said variable resistor (R₂) is adjustable so that the desired temperature is tunable within a predetermined temperature variation equal to (T2-T1)/(2^{N}-1).

20. An electronic device (100) **characterized by**:
a package housing (2) configured with a chamber (20) and having a plurality of conductive contacts (21) that are exposed outwardly of said package housing (2);
a circuit board (3) disposed in said chamber (20) and connected electrically to said conductive contacts (21) of said package housing (2);
a heating control circuit (1, 1') mounted on said circuit board (3) for heating said chamber (20) so as to maintain the temperature in said chamber (20) at a predetermined temperature; and
an electronic component (4) mounted on said circuit board (3) and operable so as to generate a predetermined output corresponding to the predetermined temperature;
wherein said heating control circuit (1, 1') includes
an operating unit (11) operable so as to generate an adjusting output corresponding to the predetermined temperature,
a control module (12, 12') connected electrically to said operating unit (11) for generating a control signal (Vₒ) in accordance with the adjusting output from said operating unit (11), and
a heater (13) connected electrically to said control module (12, 12') for heating said chamber (20) in accordance with the control signal (Vₒ) from said control module (12, 12') so as to maintain the temperature in said chamber (20) at the predetermined temperature.

21. The electronic device (100) as claimed in Claim 20, **characterized in that** said electronic component (4) is one of an active component, a passive component, and an active module having an active component.
